(19) Europäisches Patentamt
European Patent Office
Office européen des brevets

(11) EP 4 209 886 A1

(12) **EUROPEAN PATENT APPLICATION**
published in accordance with Art. 153(4) EPC

(43) Date of publication:
**12.07.2023 Bulletin 2023/28**

(21) Application number: **21874164.3**

(22) Date of filing: **31.08.2021**

(51) International Patent Classification (IPC):
***G06F 3/06*** *(2006.01)*

(52) Cooperative Patent Classification (CPC):
**G06F 3/06**

(86) International application number:
**PCT/CN2021/115618**

(87) International publication number:
**WO 2022/068503 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2020 CN 202011060780**
**28.10.2020 CN 202011176149**

(71) Applicant: **Huawei Technologies Co., Ltd.**
**Shenzhen, Guangdong 518129 (CN)**

(72) Inventors:
- **TIAN, Taixu**
**Shenzhen, Guangdong 518129 (CN)**
- **HAN, Bing**
**Shenzhen, Guangdong 518129 (CN)**

(74) Representative: **Gill Jennings & Every LLP**
**The Broadgate Tower**
**20 Primrose Street**
**London EC2A 2ES (GB)**

# (54) CIRCUIT, CHIP, AND ELECTRONIC DEVICE

(57) This application provides a circuit, a chip, and an electronic device. The circuit includes a first processor and a first processing module connected to the first processor. The first processing module includes a second processor connected to a first memory. A transmission latency generated when the second processor performs read and write operations on the first memory is less than a transmission latency generated when the first processor communicates with the first processing module. Because the transmission latency generated when the second processor performs the read and write operations on the first memory is less than the transmission latency generated when the first processor communicates with the first processing module, a cost of a transmission latency of data in a bus can be reduced.

Memory 321
Memory 322
Memory 323
333
334
335
Processor 311
332
Processor 312
332
Processor 313
Processing module 310
331
Processor 301

FIG. 3

EP 4 209 886 A1

## Description

This application claims priority to Chinese Patent Application No. 202011060780.0, filed with the China National Intellectual Property Administration on September 30, 2020 and entitled "PROCESSOR ARCHITECTURE, DEVICE, AND METHOD", and to Chinese Patent Application No. 202011176149.7, filed with the China National Intellectual Property Administration on October 28, 2020 and entitled "CIRCUIT, CHIP, AND ELECTRONIC DEVICE", which are incorporated herein by reference in their entireties.

## TECHNICAL FIELD

This application relates to the field of chip technologies, and more specifically, to a circuit, a chip, and an electronic device.

## BACKGROUND

Processors in a current high-speed network chip are generally disposed in a pipeline manner. After a packet enters the chip, a program state (program state, PS) is generated for the packet to store context information during packet forwarding. A processor on the pipeline processes the packet, saves a processing result in the PS, and then sends the processing result to a next processor. Currently, a design between the processor and a memory storing the PS that are in the chip is improper. Consequently, a high latency is generated when the PS is read and written.

## SUMMARY

This application provides a circuit, a chip, and an electronic device, to reduce a transmission latency.

According to a first aspect, an embodiment of this application provides a circuit. The circuit includes a first processor and a first processing module connected to the first processor. The first processing module includes a second processor connected to a first memory. A transmission latency generated when the second processor performs read and write operations on the first memory is less than a transmission latency generated when the first processor communicates with the first processing module. Because the transmission latency generated when the second processor performs the read and write operations on the first memory is less than the transmission latency generated when the first processor communicates with the first processing module, a cost of a transmission latency of data in a bus can be reduced.

With reference to the first aspect, in a possible implementation, the transmission latency generated when the second processor performs the read and write operations on the first memory is less than or equal to 1/10 of the transmission latency generated when the first processor communicates with the first processing module.

With reference to the first aspect, in a possible implementation, the second processor is a multi-core processor, and the transmission latency generated when the second processor performs the read and write operations on the first memory is a transmission latency generated when any core processor of the multi-core processor included in the second processor performs read and write operations on the first memory.

With reference to the first aspect, in a possible implementation, the second processor is a multi-core processor.

The transmission latency generated when the second processor performs the read and write operations on the first memory is a transmission latency generated when any core processor of the multi-core processor included in the second processor performs read and write operations on the first memory.

With reference to the first aspect, in a possible implementation, the first processor is connected to the first processing module through a first bus, and the second processor is connected to the first memory through a second bus, where a bus bit width of the second bus is greater than a bus bit width of the first bus, and/or a length of the second bus is less than a length of the first bus. Because the length of the second bus is less than the length of the first bus, an area of the circuit can be reduced.

With reference to the first aspect, in a possible implementation, a length of the second bus may be less than or equal to 1/10 of a length of the first bus. In the foregoing technical solution, an area of the circuit can be further reduced.

With reference to the first aspect, in a possible implementation, the first processing module further includes a third processor connected to a second memory, and a transmission latency generated when the third processor performs read and write operations on the second memory is less than the transmission latency generated when the first processor communicates with the first processing module.

With reference to the first aspect, in a possible implementation, the first processor is connected to the first processing module through a first bus, the second processor is connected to the first memory through a second bus, the third processor is connected to the second memory through a third bus, and a sum of a bus bit width of the second bus and a bus width of the third bus is greater than a bus bit width of the first bus.

With reference to the first aspect, in a possible implementation, the first processing module further includes a third processor connected to the first memory, and a transmission latency generated when the third processor performs read and write operations on the first memory is less than the transmission latency generated when the first processor communicates with the first processing module.

With reference to the first aspect, in a possible implementation, the first processor is connected to the first processing module through a first bus, the second processor is connected to the first memory through a second bus, the third processor is connected to the first memory through a third bus, and a sum of a bus bit width of the second bus and a bus width of the third bus is greater than a bus bit width of the first bus.

With reference to the first aspect, in a possible implementation, the second processor and the third processor are pipeline pipeline processors.

With reference to the first aspect, in a possible implementation, the circuit further includes a fourth processor and a second processing module connected to the fourth processor. The second processing module includes N fifth processors connected to M memories, where both N and M are integers greater than or equal to 1. A transmission latency generated when any fifth processor performs read and write operations on the memory connected to the fifth processor is less than a transmission latency generated when the fourth processor communicates with the second processing module.

With reference to the first aspect, in a possible implementation, the second processor is connected to the third processor through a fourth bus, the fourth processor is connected to the first processor through a fifth bus, and a bus bit width of the fourth bus is less than a bus bit width of the fifth bus.

With reference to the first aspect, in a possible implementation, a quantity of processor cores included in the fourth processor is greater than or equal to a quantity of processor cores included in the first processor.

With reference to the first aspect, in a possible implementation, the fourth processor and the first processor are pipeline processors.

With reference to the first aspect, in a possible implementation, the first processing module further includes the first memory.

According to a second aspect, an embodiment of this application further provides a chip. The chip includes the circuit according to any one of the first aspect or the possible implementations of the first aspect.

According to a third aspect, an embodiment of this application further provides an electronic device. The electronic device includes the chip according to embodiments of this application, and the electronic device further includes a receiver and a transmitter. The receiver is configured to receive a packet and send the packet to the chip. The chip is configured to process the packet. The transmitter is configured to: obtain a packet processed by the chip, and send the processed packet to another electronic device. The electronic device may be a switch, a router, or any other electronic device on which the foregoing chip can be disposed.

According to a fourth aspect, an embodiment of this application further provides a processing method. The method includes: A first processor receives a first packet, where the first packet includes flow identifier information; the first processor determines a first processing module based on the flow identifier information, where the first processing module corresponds to the flow identifier information; and the first processor sends the first packet to the first processing module.

In the foregoing method, the first processor sends, to the first processing module based on the flow identifier information carried in the packet, the packet that needs to be processed by the first processing module, and a processor in the first processing module performs corresponding processing. Because the first processing module is closer to a memory than the first processor, a transmission latency can be reduced.

Optionally, the method further includes: The first processor receives a second packet from the first processing module, where the second packet is a packet that is obtained through processing performed by the first processing module based on the flow identifier information, and the second packet includes the flow identifier information.

Optionally, the method further includes: The first processor sends the second packet to a next processor, where the next processor is a next hop of the first processor on a pipeline to which the first processor belongs.

According to a fifth aspect, an embodiment of this application further provides a processing method. The method includes: A second processor in a first processing module receives a first packet from a first processor, where the first packet includes flow identifier information; the second processor obtains, from a memory corresponding to the second processor based on the flow identifier information, a parameter used for processing the first packet; the second processor processes the first packet based on the parameter, and sends a processed first packet to a third processor in the first processing module, where the processed first packet includes the flow identifier information; the third processor in the first processing module obtains, from a memory corresponding to the third processor based on the flow identifier information, a parameter used for processing the processed first packet; and the third processor processes the processed first packet based on the parameter, to obtain a second packet and send the second packet to the first processor.

In the foregoing method, the processor in the first processing module performs a read operation on the memory based on a flow identifier in the first packet, and performs corresponding processing. Because the first processing module is closer to the memory than the first processor, a transmission latency can be reduced.

Optionally, the processing may include table lookup for forwarding, the parameter includes one or more of an index of a forwarding entry, a base address, and a hash value, and the parameter corresponds to the flow identifier.

## BRIEF DESCRIPTION OF DRAWINGS

FIG. 1 is a schematic diagram of a chip according to an embodiment of this application;
FIG. 2 is a schematic diagram of another chip according to an embodiment of this application;
FIG. 3 is a schematic diagram of a circuit;
FIG. 4 is a schematic diagram of another circuit;
FIG. 5 is a schematic flowchart of determining a next-hop port by using the circuit shown in FIG. 4; and
FIG. 6A and FIG. 6B are a schematic flowchart of determining a next-hop port by using the circuit shown in FIG. 3.

## DESCRIPTION OF EMBODIMENTS

The following describes technical solutions of this application with reference to accompanying drawings.

All aspects, embodiments, or features are presented in this application by describing a system that may include a plurality of devices, components, modules, and the like. It should be appreciated and understood that, each system may include another device, component, module, and the like, and/or may not include all devices, components, modules, and the like discussed with reference to the accompanying drawings. A combination of these solutions may also be used.

In addition, in embodiments of this application, terms such as "example" and "for example" are used to represent giving an example, an illustration, or a description. Any embodiment or design scheme described as an "example" in this application should not be explained as being more preferred or having more advantages than another embodiment or design scheme. Specifically, the term "example" is used to present a concept in a specific manner.

In embodiments of this application, "corresponding (corresponding, relevant)" and "corresponding (corresponding)" may be interchangeably used sometimes. It should be noted that meanings expressed by the terms are consistent when differences are not emphasized.

In embodiments of this application, sometimes a subscript such as $W_1$ may be written in an incorrect form such as W1. Expressed meanings are consistent when differences are not emphasized.

Network architectures and service scenarios described in embodiments of this application are intended to describe the technical solutions in embodiments of this application more clearly, and do not constitute any limitation on the technical solutions according to embodiments of this application.

A person of ordinary skill in the art may learn that the technical solutions according to embodiments of this application are also applicable to a similar technical problem as a network architecture evolves and a new service scenario emerges.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "have", and their variants all mean "include but are not limited to", unless otherwise specifically emphasized in another manner.

In this application, "at least one" means one or more, and "a plurality of" means two or more. The term "and/or" describes an association relationship between associated objects and represents that three relationships may exist. For example, A and/or B may represent the following three cases: Only A exists, both A and B exist, and only B exists. A and B each may be singular or plural. The character "/" generally represents an "or" relationship between the associated objects. "At least one of the following items (pieces)" or a similar expression thereof refers to any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural.

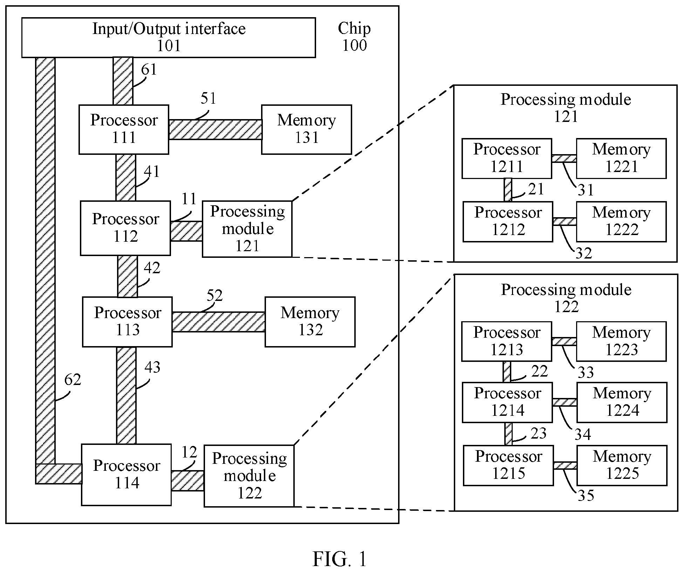

FIG. 1 is a schematic diagram of a chip according to an embodiment of this application. As shown in FIG. 1, the chip 100 includes an input/output interface 101, a processor 111, a processor 112, a processor 113, and a processor 114. The chip 100 further includes a processing module 121 and a processing module 122. The processing module 121 includes a processor 1211, a processor 1212, a memory 1221, and a memory 1222. The processing module 122 includes a processor 1213, a processor 1214, a processor 1215, a memory 1223, a memory 1224, and a memory 1225. The chip 100 further includes a memory 131 and a memory 132. The processor 111 is connected to the input/output interface 101 through a bus 61, is connected to the processor 112 through a bus 41, and is connected to the memory 131 through a bus 51. The processor 112 is connected to the processor 113 through a bus 42, and is connected to the processing module 121 through a bus 11. The processor 113 is connected to the processor 114 through a bus 43, and is connected to the memory 132 through a bus 52. The processor 114 is connected to the input/output interface 101 through a bus 62, and is connected to the processing module 122 through a bus 12. The processor 1211 is connected to the memory 1221 through a bus 31, and is connected to the processor 1212 through a bus 21. The processor 1212 is connected to the memory 1222 through a bus 32. The processor 1213 is connected to the memory 1223 through a bus 33, and is connected to the processor 1214 through a bus 22. The processor 1214 is connected to the memory 1224 through a bus 34, and is connected to the processor 1215 through a bus 23. The processor 1215 is connected to the memory 1225 through a bus 35.

The chip 100 processes a received packet in a pipeline (pipeline) manner. As shown in FIG. 1, the processor 111, the processor 112, the processor 113, and the processor 114 belong to a same pipeline, and the processor 111, the processor 112, the processor 113, and the processor 114 may also be referred to as pipeline processors. Optionally, the processor 1211 and the processor 1212 belong to a same pipeline, and the processor 1213, the processor 1214, and the processor 1215 belong to a same pipeline. For ease of description, the pipeline may be referred to as a first pipeline. As shown in FIG. 1, some processors in the first pipeline may directly access memories through buses. For example, the processor 111 may directly access the memory 131 through the bus 11, and the processor 113 may directly access the memory 132 through the bus 13. For ease of description, a processor in the first pipeline that can directly access a memory may be referred to as a type 1 processor. As shown in FIG. 1, other processors in the first pipeline may communicate with processing modules. For example, the processor 112 communicates with the processing module 121 through the bus 11, and the processor 114 communicates with the processing module 122 through the bus 12. For ease of description, a processor in the first pipeline that can communicate with a processing module may be referred to as a type 2 processor. A plurality of processors included in each processing module may also belong to a single pipeline. For example, the processor 1211 and the processor 1212 belong to the same pipeline, and the processor 1213, the processor 1214, and the processor 1215 belong to the same pipeline. For ease of description, a pipeline in a processing module may be referred to as a second pipeline. A processor in the processing module may be referred to as a type 3 processor. To be specific, the processor 1211, the processor 1212, the processor 1213, the processor 1214, and the processor 1215 shown in FIG. 1 may all be referred to as type 3 processors.

As shown in FIG. 1, any type 1 processor corresponds to one memory, and any type 3 processor corresponds to one memory. Any type 1 processor or any type 3 processor is connected to a corresponding memory through a bus, to perform read and write operations on the memory. For example, the memory 131 corresponds to the processor 111, and the memory 1221 corresponds to the processor 1211. A one-to-one correspondence between the memory and the processor may also be replaced by a one-to-many or many-to-one correspondence. For example, any type 1 processor or any type 3 processor may correspond to a plurality of memories, to perform read and write operations on a plurality of memories. Alternatively, a plurality of type 1 processors may correspond to one memory, and a plurality of type 3 processors may correspond to one memory, to perform read and write operations on the memory. For example, the memory 131 and the memory 132 in FIG. 1 may be replaced with one memory, and the processor 111 and the processor 113 correspond to the same memory. The memory 131 in FIG. 1 may alternatively be replaced with a plurality of memories, and the processor 111 corresponds to the plurality of memories. The memory 1221 and the memory 1222 in FIG. 1 may be replaced with one memory, and the processor 1211 and the processor 1212 correspond to the same memory.

Based on different connected objects, the bus in the chip 100 includes a type 1 bus, a type 2 bus, a type 3 bus, a type 4 bus, a type 5 bus, and a type 6 bus. The type 1 bus is configured to connect the type 2 processor and a processing module corresponding to the type 2 processor. For example, the bus 11 configured to connect the processor 112 and the processing module 121 and the bus 12 configured to connect the processor 114 and the processing module 122 are both type 1 buses. The type 2 bus is configured to connect two type 3 processors. For example, the bus 21 configured to connect the processor 1211 and the processor 1212, the bus 22 configured to connect the processor 1213 and the processor 1214, and the bus 23 configured to connect the processor 1214 and the processor 1215 are all type 2 buses. The type 3 bus is configured to connect the type 3 processor and a memory corresponding to the type 3 processor. For example, the bus 31 configured to connect the processor 1211 and the memory 1221, the bus 33 configured to connect the processor 1213 and the memory 1223, and the like are all type 3 buses. The type 4 bus is configured to connect two processors in the first pipeline. For example, the bus 41 configured to connect the processor 111 and the processor 112, the bus 42 configured to connect the processor 112 and the processor 113, and the bus 43 configured to connect the processor 113 and the processor 114 are all type 4 buses. The type 5 bus is configured to connect the type 1 processor and a memory corresponding to the type 1 processor. For example, the bus 51 configured to connect the processor 111 and the memory 131 and the bus 52 configured to connect the processor 113 and the memory 132 are both type 5 buses. The type 6 bus is configured to connect the input/output interface 101 and a processor. For example, the bus 61 configured to connect the input/output interface 101 and the processor 111 and the bus 62 configured to connect the processor 114 and the input/output interface 101 are both type 6 buses.

In some embodiments, each processor in the first pipeline is a multi-core processor. Each processor in the first pipeline may include a plurality of processor cores (which may also be referred to as cores (cores)). In some embodiments, different processors in the first pipeline may include a same quantity of processor cores. In other words, any two processors in the first pipeline include a same quantity of processor cores. FIG. 1 is still used as an example. A quantity of processor cores included in the processor 111 is equal to a quantity of processor cores included in the processor 112, the quantity of processor cores included in the processor 112 is equal to a quantity of processor cores included in the processor 113, and the quantity of processor cores included in the processor 113 is equal to a quantity of processor cores included in the processor 114. In other embodiments, different processors in the first pipeline may include different quantities of processor cores. In other words, any two processors in the first pipeline may include different quantities of processor cores. For example, a quantity of processor cores included in the processor 111 is greater than a quantity of processor cores included in the processor 112. A quantity of processor cores included in the processor 113 is greater than a quantity of processor cores included in the processor 114. The quantity of processor cores included in the processor 111 is greater than the quantity of processor cores included in the processor 113, and the quantity of processor cores included in the processor 112 is greater than the quantity of processor cores included in the processor 114.

In other embodiments, some processors in the first pipeline include a same quantity of processor cores. For example, a quantity of processor cores included in the processor 111 is equal to a quantity of processor cores included in the processor 113, and a quantity of processor cores included in the processor 112 is equal to a quantity of processor cores included in the processor 114, but the quantity of processor cores included in the processor 111 is different from the quantity of processor cores included in the processor 112. As described above, based on different connected objects, processors in the first pipeline may be classified into two types: a type 1 processor (for example, the processor 111 and the processor 113) and a type 2 processor (for example, the processor 112 and the processor 114). In some embodiments, processors of a same type include a same quantity of processor cores, and processors of different types may include different quantities of processor cores. In some embodiments, a quantity of processor cores included in the type 1 processor may be greater than a quantity of processor cores in the type 2 processor. The type 2 processor communicates with a processing module, and a processor included in the processing module can perform some processing operations. In this way, the type 2 processor may be a single-core processor or a processor with a small quantity of cores, so that hardware costs can be further reduced. For example, the quantity of processor cores included in the type 2 processor may be 1/2, 1/3, 1/5, or 1/8 of the quantity of processor cores included in the type 1 processor.

In other embodiments, the type 1 processor may be a multi-core processor, and the type 2 processor may be a single-core processor. In some embodiments, the type 3 processor may also be a multi-core processor. In other words, the type 3 processor may also include a plurality of processor cores. In some embodiments, a quantity of processor cores included in the type 3 processor is less than a quantity of processor cores included in the type 1 processor or a quantity of processor cores included in the type 2 processor. In other words, the quantity of processor cores included in the type 1 processor and the quantity of processor cores included in the type 2 processor are both greater than the quantity of processor cores included in the type 3 processor. For example, a quantity of processor cores included in the processor 1211 may be less than the quantity of processor cores included in the processor 111, and the quantity of processor cores included in the processor 1211 may also be less than the quantity of processor cores included in the processor 112. In other embodiments, a quantity of processor cores included in the type 3 processor may be less than a quantity of processor cores included in the type 1 processor, and the quantity of processor cores included in the type 3 processor may be equal to or greater than a quantity of processor cores included in the type 2 processor. For example, a quantity of processor cores included in the processor 1213 may be less than the quantity of processor cores included in the processor 111, and the quantity of processor cores included in the processor 1213 may be equal to or greater than the quantity of processor cores included in the processor 114. For example, in some embodiments, the quantity of processor cores included in the type 3 processor may be less than or equal to 1/10 of the quantity of processor cores included in the type 1 processor. For another example, in other embodiments, the quantity of processor cores included in the type 3 processor may be less than or equal to 1/2, 1/3, 1/5, 1/8, or the like of the quantity of processor cores included in the type 1 processor.

In other embodiments, a sum of a quantity of processor cores included in the type 2 processor and a quantity of processor cores included in one type 3 processor in a processing module corresponding to the processor is equal to a quantity of processor cores included in the type 1 processor. For example, a sum of the quantity of processor cores included in the processor 112 and a quantity of processor cores included in the processor 1212 is equal to the quantity of processor cores included in the processor 111. For another example, a sum of the quantity of processor cores included in the processor 114 and a quantity of processor cores included in the processor 1214 is equal to the quantity of processor cores included in the processor 113. In some embodiments, different type 3 processors may include a same quantity of processor cores. For example, the quantity of processor cores included in the processor 1211 is equal to the quantity of processor cores included in the processor 1212, and the quantity of processor cores included in the processor 1212 is equal to a quantity of processor cores included in the processor 1215.

In other embodiments, different type 3 processors may include different quantities of processor cores.

In other embodiments, any two processors belonging to a same processing module include a same quantity of processor cores, and two processors belonging to different processing modules include different quantities of processor cores. For example, the quantity of processor cores included in the processor 1211 is equal to the quantity of processor cores included in the processor 1212, and the quantity of processor cores included in the processor 1212 is not equal to the quantity of processor cores included in the processor 1213. In the chip shown in FIG. 1, each processing module includes at least two processors. In other embodiments, the processing module may alternatively include one multi-core processor. For example, the processing module 121 may include only the processor 1211 and the memory 1221, where the processor 1211 is a multi-core processor.

In some embodiments, the type 2 processor may also be a single-core processor. If the type 2 processor is a single-core processor, a processing module including the processor may include at least two processors. In other words, if the processing module includes a plurality of processors, the plurality of processors may include at least one single-core processor. The processing module 121 is used as an example. The processor 1211 in the processing module 121 may be a single-core processor, and the processor 1212 may be a single-core processor or a multi-core processor.

In some embodiments, a length of the type 1 bus is greater than a length of the type 3 bus. For example, the length of the type 3 bus may be equal to 1/5, 1/8, 1/10, or the like of the length of the type 1 bus. For another example, the length of the type 3 bus may be less than 1/10, 1/15, 1/20, or the like of the length of the type 1 bus. In some embodiments, a sum of the length of the type 1 bus and the length of the type 3 bus is equal to a length of the type 5 bus.

In some embodiments, any two type 1 buses may have a same length. In some embodiments, any two type 2 buses may have a same length. In some embodiments, any two type 3 buses may have a same length. In some embodiments, any two type 4 buses may have a same length. In some embodiments, any two type 5 buses may have a same length. Due to limitations of a manufacturing process, it may be difficult to obtain buses of a completely same length. Therefore, in this embodiment of this application, that lengths are the same may be understood as that the lengths are completely the same, or may be understood as that a length difference is within an allowed error range. For example, that a sum of the length of the type 1 bus and the length of the type 3 bus is equal to a length of the type 5 bus may be understood as that a difference between the sum of the length of the type 1 bus and the length of the type 3 bus and the length of the type 5 bus is 0, or is less than or equal to a preset allowed error value. For another example, a difference between a length of the bus 51 and a length of the bus 52 (that is, lengths of two type 5 buses) is 0, or is less than or equal to a preset allowed error value.

In some embodiments, a sum of widths of all third buses in a same processing module is greater than a width of one first bus. For example, a sum of a width of the bus 31 and a width of the bus 32 is greater than a width of the bus 11. For another example, a sum of a width of the bus 33, a width of the bus 34, and a width of the bus 35 is greater than a width of the bus 12. A quantity of bits of binary data that can be simultaneously transmitted through the bus is referred to as a width (width) (which may also be referred to as a bit width), and the width is measured in bits. A greater bus width indicates better transmission performance and a larger amount of data that can be transmitted within a same period. A formula for calculating a bus bandwidth (a total amount of data that can be transmitted per unit time) is as follows: Bus bandwidth=Frequency×Width (bytes/sec).

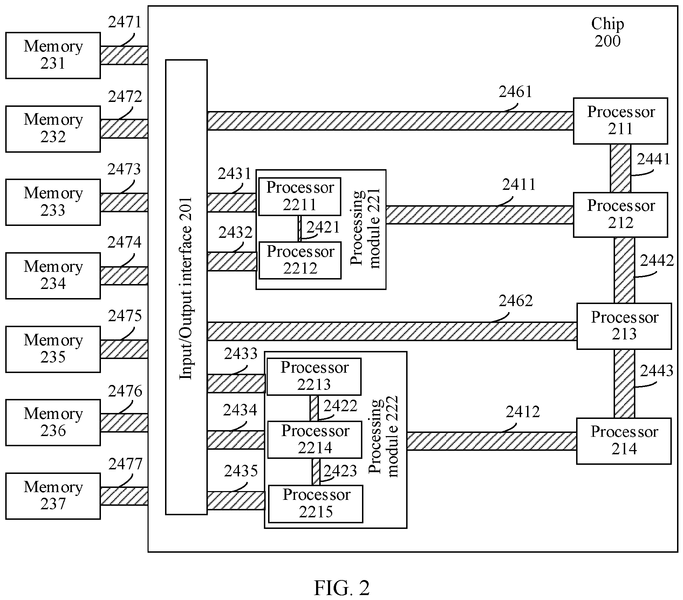

In some embodiments, a width of the type 2 bus may be less than a width of the type 4 bus. FIG. 2 is a schematic diagram of another chip according to an embodiment of this application. As shown in FIG. 2, the chip 200 includes an input/output interface 201, a processor 211, a processor 212, a processor 213, and a processor 214. The chip 200 further includes a processing module 221 and a processing module 222. The processing module 221 includes a processor 2211 and a processor 2212. The processing module 222 includes a processor 2213, a processor 2214, and a processor 2215.

The processor 211 is connected to the input/output interface 201 through a bus 2411. The processor 211 is connected to the processor 212 through a bus 2441. The processor 212 is connected to the processing module 221 through a bus 2421. The processor 212 is connected to the processor 213 through a bus 2442. The processor 213 is connected to the input/output interface 201 through a bus. The processor 213 is connected to the processor 214 through a bus 2443. The processor 214 is connected to the processing module 222 through a bus 2422. The processing module 221 is connected to the input/output interface 201 through a bus 2431. The processing module 222 is connected to the input/output interface 201 through a bus 2432. The processor 2221 is connected to the processor 2212 through a bus 2451. The processor 2213 is connected to the processor 2214 through a bus 2452. The processor 2214 is connected to the processor 2215 through a bus 2453. A memory 231 to a memory 237 are memories located outside the chip 200. The chip 200 may access the memory 231 to the memory 237 through the input/output interface 201 and corresponding buses. Specifically, the memory 231 is connected to the chip 200 through a bus 2461, the memory 232 is connected to the chip 200 through a bus 2462, the memory 233 is connected to the chip 200 through a bus 2463, the memory 234 is connected to the chip 200 through a bus 2464, the memory 235 is connected to the chip 200 through a bus 2465, the memory 236 is connected to the chip 200 through a bus 2466, and the memory 237 is connected to the chip 200 through a bus 2467.

The chip 200 processes a received packet in a pipeline (pipeline) manner. As shown in FIG. 2, the processor 211, the processor 212, the processor 213, and the processor 214 in the chip 200 belong to a single pipeline, and the pipeline may be referred to as a first pipeline. As shown in FIG. 2, some processors in the first pipeline can directly communicate with the input/output interface through buses, and other processors in the first pipeline are connected to processing modules through buses. For ease of description, a processor that can directly communicate with the input/output interface (namely, a processor that is not connected to a processing module) may be referred to as a type 1 processor, and a processor connected to a processing module may be referred to as a type 2 processor. For example, in FIG. 2, the type 1 processor may include the processor 211 and the processor 213, and the type 2 processor may include the processor 212 and the processor 214.

A plurality of processors included in each processing module may also belong to a single pipeline. For example, the processor 2211 and the processor 2212 belong to a same pipeline, and the processor 2213, the processor 2214, and the processor 2215 belong to a same pipeline. For ease of description, a pipeline in a processing module may be referred to as a second pipeline. A processor in the processing module may be referred to as a type 3 processor. To be specific, the processor 2211, the processor 2212, the processor 2213, the processor 2214, and the processor 2215 shown in FIG. 2 may all be referred to as type 3 processors.

Each type 1 processor and each processor have one corresponding memory. The processor may read data stored in the corresponding memory. The processor may also write the data into the corresponding memory. In FIG. 2, a memory corresponding to the processor 211 is the memory 231, a memory corresponding to the processor 2211 is the memory 232, a memory corresponding to the processor 2212 is the memory 233, a memory corresponding to the processor 213 is the memory 234, a memory corresponding to the processor 2213 is the memory 235, a memory corresponding to the processor 2214 is the memory 236, and a memory corresponding to the processor 2215 is the memory 237. For example, the processor 211 may read data stored in the memory 231, and/or write the data into the memory 231. For another example, the processor 2213 may read data stored in the memory 235, and/or write the data into the memory 235.

A processing module connected to a processor through a bus may be referred to as a processing module corresponding to the processor. For example, the processing module 121 is a processing module corresponding to the processor 112.

Based on different connected objects, the bus in the chip 200 may include a type 1 bus, a type 2 bus, a type 3 bus, a type 4 bus, a type 5 bus, and a type 6 bus. The type 1 bus is configured to connect the type 2 processor and a processing module corresponding to the type 2 processor. For example, the bus 2411 configured to connect the processor 212 and the processing module 221 and the bus 2412 configured to connect the processor 214 and the processing module 222 are both type 1 buses. The type 2 bus is configured to connect two type 3 processors. For example, the bus 2421 configured to connect the processor 2221 and the processor 2212, the bus 2422 configured to connect the processor 2213 and the processor 2214, and the bus 2423 configured to connect the processor 2214 and the processor 2215 are all type 2 buses. The type 3 bus is configured to connect a processor in a processing module and the input/output interface. For example, the bus 2431, the bus 2432, the bus 2433, the bus 2434, and the bus 2435 are all type 3 buses. The bus 2431 is a type 3 bus configured to connect the processor 2211 and the input/output interface 201. The bus 2432 is a type 3 bus configured to connect the processor 2212 and the input/output interface 201. The bus 2433 is a type 3 bus configured to connect the processor 2213 and the input/output interface 201. The bus 2434 is a type 3 bus configured to connect the processor 2214 and the input/output interface 201. The bus 2435 is a type 3 bus configured to connect the processor 2215 and the input/output interface 201. The type 4 bus is configured to connect two processors in the first pipeline. For example, the bus 2441 configured to connect the processor 211 and the processor 212, the bus 2442 configured to connect the processor 212 and the processor 213, and the bus 2443 configured to connect the processor 213 and the processor 214 are all type 4 buses. The type 6 bus is configured to connect the first processor and the input/output interface. For example, the bus 2461 and the bus 2462 are both type 6 buses.

In addition to the buses in the chip 200, the chip 200 is further connected to memories through buses. The bus 2471 to the bus 2477 are buses configured to connect the chip 200 and the memories, and the bus may be referred to as a type 7 bus. The type 1 processor may access a corresponding memory through corresponding buses and the input/output interface. For example, the processor 211 may access the memory 231 through the bus 2461, the input/output interface 201, and the bus 2471. For another example, the processor 213 may access the memory 234 through the bus 2462, the input/output interface 201, and the bus 2474. The type 3 processor may access a corresponding memory through corresponding buses and the input/output interface. For example, the processor 2211 may access the memory 232 through the bus 2431, the input/output interface 201, and the bus 2472. For another example, the processor 2215 may access the memory 237 through the bus 2435, the input/output interface 201, and the bus 2477.

Similar to the chip shown in FIG. 1, in some embodiments, processors shown in FIG. 2 may all be multi-core processors. In other embodiments, the type 1 processor and the type 2 processor may be multi-core processors, and the type 3 processor may be a single-core processor. A structure of the type 3 processor may be simpler than a structure of the type 1 processor. For example, a quantity of processor cores included in the type 3 processor may be less than a quantity of processor cores included in the type 1 processor. For another example, a quantity of transistors included in the type 3 processor may be less than a quantity of transistors included in the type 1 processor. For specific cases of the type 1 processor, the type 2 processor, and the type 3 processor, refer to descriptions of the chip 100 shown in FIG. 1. For brevity, details are not described herein again.

In some embodiments, a length of the type 1 bus is greater than a length of the type 3 bus. For example, the length of the type 1 bus may be equal to 1/5, 1/8, 1/10, or the like of the length of the type 3 bus. For another example, the length of the type 3 bus may be less than 1/10, 1/15, 1/20, or the like of the length of the type 1 bus. In some embodiments, a sum of the length of the type 1 bus and the length of the type 3 bus is equal to a length of the type 6 bus. In some embodiments, any two type 1 buses may have a same length. In some embodiments, any two type 2 buses may have a same length. In some embodiments, any two type 3 buses may have a same length. In some embodiments, any two type 4 buses may have a same length. In some embodiments, any two type 6 buses may have a same length.

In some embodiments, a sum of widths of buses between the chip and memories corresponding to a same processing module is greater than a width of one first bus. For example, a sum of a width of the bus 2431 and a width of the bus 2432 is greater than a width of the bus 2411. For another example, a sum of a width of the bus 2433, a width of the bus 2434, and a width of the bus 2435 is greater than a width of the bus 2412. In some embodiments, a width of the type 2 bus may be less than a width of the type 4 bus. In the embodiment shown in FIG. 1, each processor (the type 3 processor and the type 1 processor) that has a corresponding memory and the corresponding memory are located inside the chip.

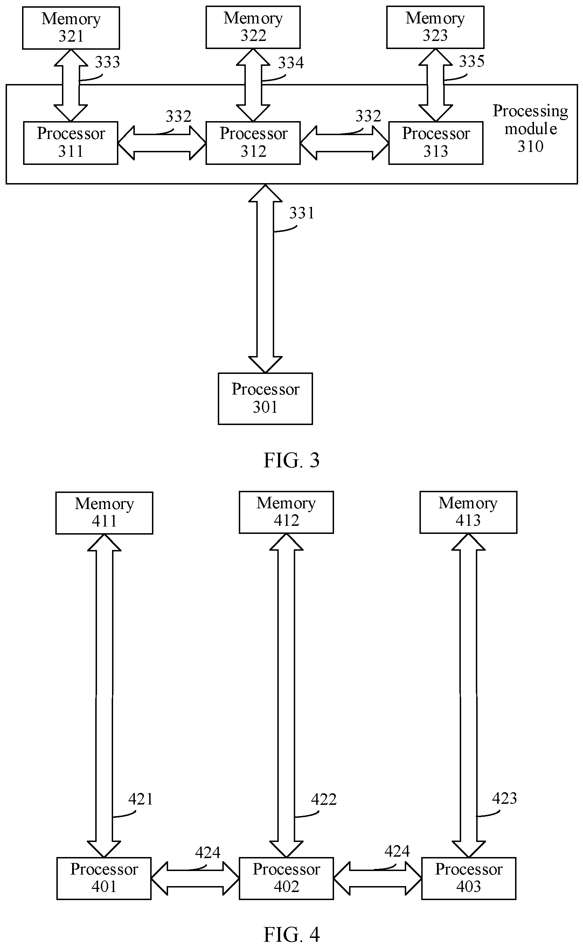

In the embodiment shown in FIG. 2, a memory corresponding to a processor is located outside the chip. In other embodiments, a part of memories corresponding to processors may be located inside the chip, and the other part of memories corresponding to processors may be located outside the chip. This embodiment may be considered as a combination of the embodiment shown in FIG. 1 and the embodiment shown in FIG. 2. It can be learned that the chip shown in FIG. 1 or FIG. 2 includes two structures shown in FIG. 3. FIG. 3 is a schematic diagram of a hybrid processor circuit. As shown in FIG. 3, a processor 301 is connected to a processing module 310 through a bus 331. The processing module 310 includes three processors, which are respectively a processor 311, a processor 312, and a processor 313. The processors in the processing module 310 are connected through a bus 332. The processor 301 is a first processor, and the processor 311, the processor 312, and the processor 313 are type 3 processors. More specifically, the processor 311 is a type 2 processor. Each processor in the processing module 310 has one corresponding memory. A memory corresponding to the processor 311 is a memory 321, a memory corresponding to the processor 312 is a memory 322, and a memory corresponding to the processor 313 is a memory 323. Each processor in the processing module 310 is connected to the corresponding memory through a bus. The processor 311 is connected to the memory 321 through a bus 333, the processor 312 is connected to the memory 322 through a bus 334, and the processor 313 is connected to the memory 323 through a bus 335. The processor 310, the processor 311, the processor 312, and the processor 313 are located in a same chip. The corresponding memory of each processor in the processing module 310 may be located in a same chip as the processing module 310, or may be located outside a chip in which the processing module 310 is located. If the memory is located outside the chip in which the processing module 310 is located, the bus configured to connect the processor in the processing module and the corresponding memory may include a bus from the processor to an input/output interface of the chip and a bus from the chip to the corresponding memory. For example, the bus 333 may include a bus from the processor 311 to the input/output interface of the chip and a bus from the input/output interface of the chip to the memory 321.

For ease of description, the structure shown in FIG. 3 may be referred to as a hybrid processor circuit or a hybrid processor structure. The processing module in the hybrid processor structure shown in FIG. 3 includes three processors. In other embodiments, a quantity of processors in the processing module may be a positive integer greater than or equal to 1. For example, the quantity may be 1, 2, 4, 5, or the like. As described above, if the processing module includes one processor, the processor may be a multi-core processor. If the processing module includes at least two processors, the at least two processors may include one or more single-core processors.

For ease of description, it is assumed that a length of the bus 333, a length of the bus 334, and a length of the bus 335 are the same. A letter L is used to represent the length of the bus 333, and a letter R is used to represent a length of the bus 331. As described in the foregoing embodiments, in some embodiments, L is less than R. In other embodiments, L may be far less than R. For example, L may be equal to one tenth of R, or L is less than one tenth of R. It is assumed that a letter A is used to represent a width of the bus 333, a letter B is used to represent a width of the bus 334, a letter C is used to represent a width of the bus 335, and a letter D is used to represent a width of the bus 331. In this case, A, B, C, and D meet the following relationship: $D<A+B+C$. In this way, a data transfer cost of the hybrid processor structure shown in FIG. 3 may be shown in formula 3.1:

$$\mathrm{Cost_TX}=L\times(A+B+C)+R\times D \quad \text{(formula 3.1)}$$

Cost_TX represents the data transfer cost, L represents the length of the bus 333 (the length of the bus 333,

the length of the bus 334, and the length of the bus 335 are equal), R represents the length of the bus 331, A represents the width of the bus 333, B represents the width of the bus 334, C represents the width of the bus 335, and D represents the width of the bus 331.

After receiving a packet, a chip (for example, the chip 100 shown in FIG. 1 or the chip 200 shown in FIG. 2) that uses a pipeline structure may generate a program state (program state, PS) for the packet. The PS is used to store context information during packet forwarding. The PS passes through each processor in a first pipeline, and the processor in the first pipeline is responsible for processing. For ease of description, the PS processed by the processor in the first pipeline may be referred to as a first PS. It is assumed that PS_Full_Size represents a size of the first PS. The processing module 310 also generates a PS in a process of processing the packet. The PS sequentially passes through each processor in a second pipeline, and the processors in the second pipeline are responsible for processing. For ease of description, the PS processed by the processor in the second pipeline may be referred to as a second PS. It is assumed that PS_Little_Size represents a size of the second PS. The first PS stores the context information during the packet forwarding. The second PS stores only information processed in the second pipeline. Therefore, the size of the first PS is greater than the size of the second PS (that is, PS_Full_Size>PS_Little_Size). In some embodiments, the size of the second PS may be equal to or less than 1/5, 1/8, 1/10, 1/15, 1/20, or the like of the size of the first PS.

Since the size of the second PS is less than the size of the first PS, a simpler processor may be used to process the second PS. Therefore, a structure of the processor (namely, the type 3 processor) inside the processing module may be simpler than a structure of the processor in the first pipeline. To be specific, a quantity of processor cores included in the type 3 processor may be less than a quantity of processor cores included in the type 1 first processor and/or a quantity of processor cores included in the type 2 first processor, and/or a quantity of transistors included in the type 3 processor may be less than a quantity of transistors included in the type 1 processor and/or a quantity of transistors included in the type 2 processor. A greater difference between the size of the first PS and the size of the second PS indicates a simpler structure of the type 3 processor.

In some embodiments, the quantity of processor cores included in the type 3 processor may be less than the quantity of processor cores included in the type 1 processor, and/or the quantity of transistors included in the type 3 processor may be less than the quantity of transistors included in the type 1 processor. In other embodiments, the quantity of processor cores included in the type 3 processor may be less than the quantity of processor cores included in the type 2 processor, and/or the quantity of transistors included in the type 3 processor may be less than the quantity of transistors included in the type 2 processor.

A quantity of processor cores is used as an example. N_Little may be used to represent the quantity of processor cores included in the type 3 processor, N_Big2 may be used to represent the quantity of processor cores included in the type 2 processor, and N_Big1 may be used to represent the quantity of processor cores included in the type 1 processor.

In this way, a processor cost of the hybrid processor structure shown in FIG. 3 may be shown in formula 3.2:

$$\text{Cost_Proc}=\text{PS_Little_Size}\times\text{N_Little}+\text{PS_Full_Size}\times\text{N_Big2} \text{ (formula 3.2)}$$

Cost_Proc represents the processor cost, and meanings of PS_Little_Size, N_Little, PS_Full_Size, and N_Big2 are described above. For brevity, details are not described herein again.

In some embodiments, N_Little, N_Big2, and N_Big1 may meet the following relationship: N_Big1=N_Little+N_Big2.

If Latency_L is used to represent an input/output (Input/Output, I/O) latency of a bus whose length is L, and Latency_R is used to represent an I/O latency of a bus whose length is R, a latency cost generated when using the hybrid processor structure shown in FIG. 3 may be shown in formula 3.3:

$$\text{Cost_LAT}=\text{Latency_L}\times 3+\text{Latency_R}\times 1 \text{ (formula 3.3)}$$

Cost_LAT represents the latency cost, Latency _L represents the I/O latency of the bus whose length is L, and Latency _R represents the I/O latency of the bus whose length is R.

If processors in one pipeline implement functions implemented by the hybrid processing structure shown in FIG. 3, a structure shown in FIG. 4 is required.

FIG. 4 is a schematic diagram another circuit including processors. The circuit shown in FIG. 4 includes three processors: a processor 401, a processor 402, and a processor 403. In addition, the processor 401, the processor 402, and the processor 403 are type 1 processors (the processor 401 to the processor 403 are all processors in a same pipeline, and the processor 401 to the processor 403 are connected to memories rather than processing modules through buses). Each of the three processors has a corresponding memory. A memory corresponding to the processor 401 is a memory 411, a memory corresponding to the processor 402 is a memory 412, and a memory corresponding to the processor 403 is a memory 413. The processor 401 is connected to the memory 411 through a bus 421, the processor 402 is connected to the memory 412 through a bus 422, and the processor 402 is connected to the memory 413 through a bus 423. The processor 401 is connected to the processor 402 through a bus 424, and the processor 402 is connected to the processor 403 through a bus 424.

The bus 421, the bus 422, and the bus 423 have a same length. The length of the bus 421 may be equal to L+R, namely, a sum of the length of the bus 333 and the length of the bus 331 shown in FIG. 3. A width of the bus 421 may be equal to the width of the bus 333, a width of the bus 422 may be equal to the width of the bus 334, and a width of the bus 423 may be equal to the width of the bus 335. In this case, a data transfer cost generated when using a structure shown in FIG. 4 may be shown in formula 4.1:

$$Cost_TX=(L+R)\times(A+B+C) \text{ (formula 4.1)}$$

Cost_TX represents the data transfer cost, L+R is the length of the bus 421 (the length of the bus 422 is equal to the length of the bus 421, and the length of the bus 423 is equal to the length of the bus 421), A represents the width of the bus 421, B represents the width of the bus 422, and C represents the width of the bus 423.

Through comparison between formula 4.1 and formula 3.1, it can be found that, in a case in which L is less than R and D is less than A+B+C, the data transfer cost generated when using the structure shown in FIG. 3 is less than the data transfer cost generated when using the structure shown in FIG. 4.

In some embodiments, a greater difference between R and L indicates a lower data transfer cost of the structure shown in FIG. 3.

As described above, because the processor 401 to the processor 403 are all type 1 processors, a PS passing through the processor 401 to the processor 403 is PS_Full. Correspondingly, a size of PS_Full is PS_Full_Size, and a quantity of processor cores included in the type 1 processor of is N_Big1. In this case, a processor cost generated when using the structure shown in FIG. 4 may be shown in formula 4.2:

$$Cost_Proc=PS_Full_Size\times N_Big1 \text{ (formula 4.2)}$$

Cost_Proc represents the processor cost, PS_Full_Size is the size of the PS that passes through the processor 401, and N_Big1 is the quantity of processor cores included in the processor 401.

If N_Big1=N_Little+N_Big2, compared with the structure shown in FIG. 4, the processor cost generated when using the structure shown in FIG. 3 may be reduced by (PS_Full_Size-PS_Little_Size)×N_Little. A greater difference between PS_Full_Size and PS_Little_Size indicates a more reduced processor cost (that is, a lower processor cost). A greater difference between N_Big1 and N_Little1 indicates a more reduced processor cost (that is, a lower processor cost).

If Latency _L is used to represent an I/O latency of a bus whose length is L, and Latency R is used to represent an I/O latency of a bus whose length is R, a latency cost generated when using the structure shown in FIG. 4 may be shown in formula 4.3:

$$Cost_LAT=(Latency_L+Latency_R)\times 3 \text{ (formula 4.3)}$$

Cost_LAT represents the latency cost, Latency _L represents the I/O latency of the bus whose length is L, and Latency _R represents the I/O latency of the bus whose length is R.

It can be learned that, compared with the structure shown in FIG. 4, the structure shown in FIG. 3 can reduce an I/O latency of Latency_R×2. A greater difference between R and L indicates a more reduced I/O latency.

In conclusion, in the technical solutions according to embodiments of this application, corresponding functions can be implemented using lower costs (a lower data transfer cost, a lower processor cost, and a lower latency cost). In addition, because a length of a bus required inside a processing module is short and a width of a bus between a type 2 first processor and the processing module is small, compared with a chip that implements a same function, an area of a chip using the technical solutions of this application is small.

The following describes two structures in FIG. 3 and FIG. 4 by using equal-cost multi-path routing (equal-cost multi-path routing, ECMP) as an example.

A basic process of determining a next-hop port by the ECMP is as follows: A hash value is determined based on flow identifier information (for example, a quintuple or a flow label (flow label)) of a packet, and then an entry is determined based on an ECMP routing table and the hash value, where a port included in the entry is a next-hop port for sending the packet.

In some cases, to reduce entries stored in the ECMP routing table and improve lookup efficiency, the ECMP routing table may be divided into a plurality of tables, for example, may be divided into three tables, which are respectively referred to as a routing entry table 1, a routing entry table 2, and a routing entry table 3. First, based on the flow identifier information of the packet, an entry corresponding to the flow identifier information is determined from the routing entry table 1, where the entry includes one base address and an index of one routing entry table. Then, the routing entry table 2 is determined based on the index of the routing entry table, and an entry corresponding to the base address and the hash value determined based on the flow identifier information of the packet is queried from the routing entry table 2, where the entry includes one port index and an index of one routing entry table. Finally, the routing entry table 3 is determined based on the index of the routing entry table, and an entry corresponding to the port index is queried from the routing entry table 3, where the entry includes a next-hop port for the packet.

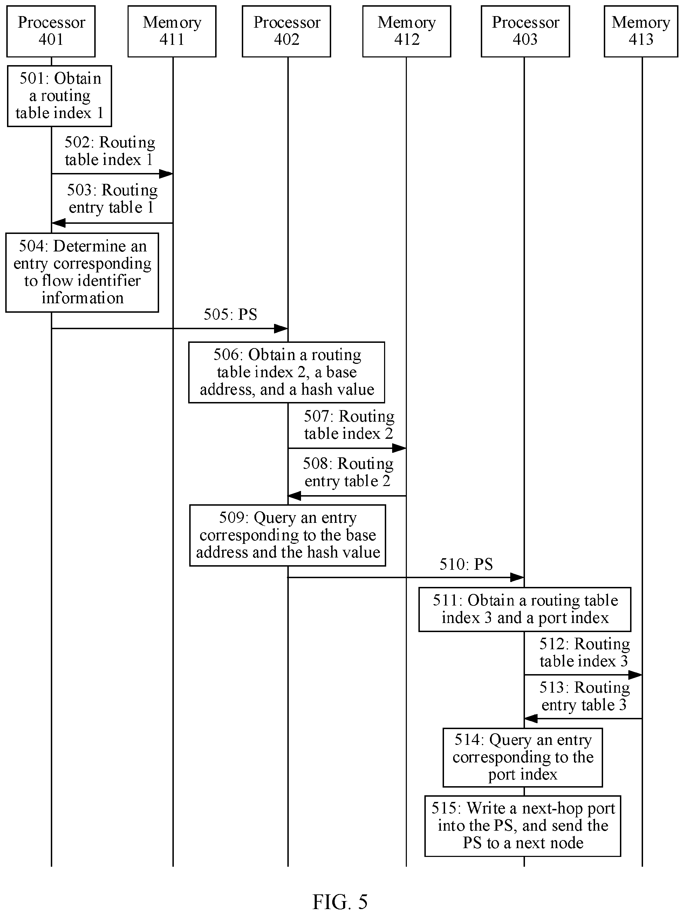

FIG. 5 is a schematic flowchart of determining a next-hop port by using the circuit shown in FIG. 4.

501: The processor 401 obtains an index (referred to as a routing table index 1 below) of one routing entry table from a received PS.

502: The processor 401 sends the routing table index 1 to the memory 411.

503: The processor 401 receives, from the memory 411, a routing entry table 1 corresponding to the routing table index 1.

504: The processor 401 determines, from the routing entry table 1, an entry corresponding to flow identifier information of a packet. The entry includes an index (referred to as a routing table index 2 below) of one routing entry table and one base address, and the routing table index 2 and the base address are written into the PS.

505: The processor 401 sends the PS (namely, the PS into which the routing table index 2 and the base address are written) to the processor 402.

506: The processor 402 obtains the routing table index 2, the base address, and one hash value from the received PS. The hash value is determined based on the flow identifier information of the packet. The hash value may be determined by an upstream node of the processor 401 and written into the PS.

507: The processor 402 sends the routing table index 2 to the memory 412.

508: The processor 402 receives, from the memory 412, a routing entry table 2 corresponding to the routing table index 2.

509: The processor 402 queries, from the routing entry table 2, an entry corresponding to the base address and the hash value, where the entry includes one port index and an index (referred to as a routing table index 3 below) of one routing entry table, and writes the port index and the routing table index 3 into the PS.

510: The processor 402 sends the PS (namely, the PS into which the port index and the routing table index 3 are written) to the processor 403.

511: The processor 403 obtains the routing table index 3 and the port index from the received PS.

512: The processor 403 sends the routing table index 3 to the memory 413.

513: The processor 403 receives, from the memory 412, a routing entry table 3 corresponding to the routing table index 3.

514: The processor 403 queries, from the routing entry table 3, an entry corresponding to the port index, where content included in the entry is a next-hop port for the packet.

515: The processor 403 writes the next-hop port for the packet into the PS, and sends the PS to a next node in a pipeline, so that the next node continues to process the packet.

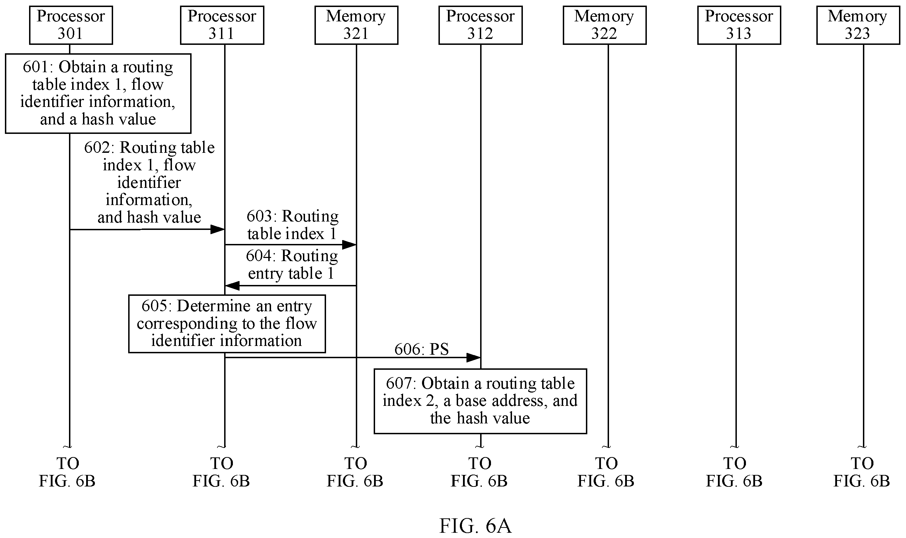

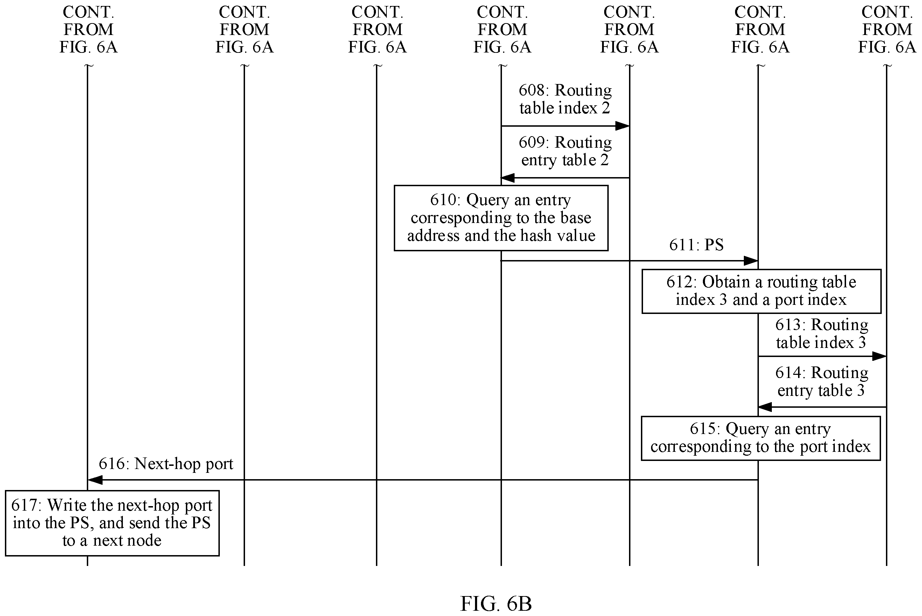

FIG. 6A and FIG. 6B are a schematic flowchart of determining a next-hop port by using the circuit shown in FIG. 3.

601: The processor 301 obtains, from a received PS, an index (referred to as a routing table index 1 below) of one routing entry table, flow identifier information of a packet, and a hash value determined based on the flow identifier information of the packet.

602: The processor 301 sends, to the processor 311, the routing table index 1, the flow identifier information of the packet, and the hash value determined based on the flow identifier information of the packet.

603: The processor 311 sends the routing table index 1 to the memory 321.

604: The processor 311 receives, from the memory 321, a routing entry table 1 corresponding to the routing table index 1.

605: The processor 311 determines, from the routing entry table 1, an entry corresponding to the flow identifier information of the packet. The entry includes an index (referred to as a routing table index 2 below) of one routing entry table and one base address, and the routing table index 2 and the base address are written into the PS. The PS may further include the hash value determined based on the flow identifier information of the packet.

606: The processor 311 sends the PS (namely, the PS into which the routing table index 2 and the base address are written) to the processor 312.

607: The processor 312 obtains the routing table index 2, the base address, and the hash value from the received PS.

608: The processor 312 sends the routing table index 2 to the memory 322.

609: The processor 312 receives, from the memory 322, a routing entry table 2 corresponding to the routing table index 2.

610: The processor 312 queries, from the routing entry table 2, an entry corresponding to the base address and the hash value, where the entry includes one port index and an index (referred to as a routing table index 3 below) of one routing entry table, and writes the port index and the routing table index 3 into the PS.

611: The processor 312 sends the PS (namely, the PS into which the port index and the routing table index 3 are written) to the processor 313.

612: The processor 313 obtains the routing table index 3 and the port index from the received PS.

613: The processor 313 sends the routing table index 3 to the memory 323.

614: The processor 313 receives, from the memory 323, a routing entry table 3 corresponding to the routing table index 3.

615: The processor 313 queries, from the routing entry table 3, an entry corresponding to the port index, where content included in the entry is a next-hop port for the packet.

616: The processor 313 sends the next-hop port for the packet to the processor 301.

617: The processor 301 writes the next-hop port for the packet into the PS, and sends the PS to a next node in a pipeline, so that the next node continues to process the packet.

In a procedure shown in FIG. 5, the processor 401 to the processor 403 and other processors in a chip all belong to the same pipeline. The PS processed by the processor in the pipeline is used to store context information during packet forwarding. Therefore, the PS sent by the processor 401 to the processor 402 and the PS sent by the processor 402 to the processor 403 need to include information required by a subsequent node in addition to information required for querying a next-hop port. Therefore, a size of the PS is large. For example, the size of the PS may be 512 bytes. Correspondingly, a width of a bus between processors is also large.

However, in a procedure shown in FIG. 6A and FIG. 6B, the processor 311 to the processor 313 only care about a routing function, and the transferred PS only needs to include information required for routing. Therefore, setting a PS of a small size may meet requirements of the processor 311 to the processor 313. For example, a 64-byte PS may meet routing requirements. Correspondingly, a bus of a small width may be set between processors. In addition, information required by the processor 312 and information required by the processor 313 are both from previous nodes, and the information does not need to be obtained from the processor 301. In addition, for the processor 301, the processor 301 only cares about a determined next-hop port, the processor 301 may not need to obtain the routing entry table 3 for determining the next-hop port, and the processor 301 does not need to send, to the processing module 310, information irrelevant to the determining of the next-hop port. Therefore, a bus of a small width may be set between the processor 301 and the processing module 310. For example, a width of the bus 331 may be 128 bits (bits). In comparison, because a large amount of information (for example, a routing entry table) needs to be transmitted through a bus between a processor and a memory, a large width is required. For example, widths of the bus 333 to the bus 335 may be 256 bits, and widths of the bus 421 to the bus 423 may be 256 bits.

An embodiment of this application further provides a circuit. The circuit includes a first processor and a first processing module connected to the first processor. The first processing module includes a second processor connected to a first memory. A transmission latency generated when the second processor performs read and write operations on the first memory is less than a transmission latency generated when the first processor communicates with the first processing module.

For example, it is assumed that the processor module 121 shown in FIG. 1 includes only the processor 1221 and the memory 1221. In this case, the first processor may be equivalent to the processor 112, the first processing module may be equivalent to the processing module 121, the second processor may be equivalent to the processor 1211, and the first memory may be equivalent to the memory 1221. A transmission latency generated when the processor 1211 performs read and write operations on the memory 1221 is less than a transmission latency generated when the processor 112 communicates with the processing module 1.

For another example, it is assumed that the processing module 221 shown in FIG. 2 includes only the processor 2211. In this case, the first processor may be equivalent to the processor 212, the first processing module may be equivalent to the processing module 221, the second processor may be equivalent to the processor 2211, and the first memory may be equivalent to the memory 323.

Optionally, in some embodiments, the second processor is a multi-core processor, and the transmission latency generated when the second processor performs the read and write operations on the first memory is a transmission latency generated when any core processor of the multi-core processor included in the second processor performs read and write operations on the first memory.

Optionally, in some embodiments, the first processor is connected to the first processing module through a first bus, and the second processor is connected to the first memory through a second bus, where a bus bit width of the second bus is greater than a bus bit width of the first bus, and/or a length of the second bus is less than a length of the first bus.

For example, it is still assumed that the processing module 121 shown in FIG. 1 includes only the processor 1221 and the memory 1221. The first bus is equivalent to the bus 11 configured to connect the processor 112 and the processing module 121, and the second bus is equivalent to the bus 31 configured to connect the processor 1211 and the memory 1221.

For another example, it is still assumed that the processing module 221 shown in FIG. 2 includes only the processor 221. The first bus is equivalent to the bus 2411 configured to connect the processor 212 and the processing module 221, and the second bus may be equivalent to buses configured to connect the processor 2211 and the memory 232, including the bus 2431 and the bus 2472. The second bus may also be equivalent to the bus 2431 configured to connect the processor 2211 and the input/output interface 201.

Optionally, in some embodiments, the first processing module further includes a third processor connected to a second memory, and a transmission latency generated when the third processor performs read and write operations on the second memory is less than the transmission latency generated when the first processor communicates with the first processing module.

FIG. 1 is used as an example. The first processor may be equivalent to the processor 112, the first processing module may be equivalent to the processing module 121, the second processor may be equivalent to the processor 1211, the third processor may be equivalent to the processor 1212, the first memory may be equivalent to the memory 1221, and the second memory may be equivalent to the memory 1222. A transmission latency generated when the processor 1211 performs read and write operations on the memory 1221 is less than a transmission latency generated when the processor 112 communicates with the processing module 121, and a transmission latency generated when the processor 1212 performs read and write operations on the memory 1222 is less than the transmission latency generated when the processor 1122 communicates with the processing module 121.

FIG. 2 is used as an example. The first processor may be equivalent to the processor 212, the first processing module may be equivalent to the processing module 221, the second processor may be equivalent to the processor 2211, the third processor may be equivalent to the processor 2212, the first memory may be equivalent to the memory 232, and the second memory may be equivalent to the memory 233.

Optionally, in some embodiments, the first processor is connected to the first processing module through a first bus, the second processor is connected to the first memory through a second bus, the third processor is connected to the second memory through a third bus, and a sum of a bus bit width of the second bus and a bus width of the third bus is greater than a bus bit width of the first bus.

FIG. 1 is still used as an example. The first bus may be equivalent to the bus 11, the second bus may be equivalent to the bus 31, and the third bus may be equivalent to the bus 32.

FIG. 2 is still used as an example. The first bus may be equivalent to the bus 2411, the second bus may be equivalent to the bus 2431 and the bus 2472, and the third bus may be equivalent to the bus 2432 and the bus 2473. The second bus may also be equivalent to the bus 2431, and the third bus may also be equivalent to the bus 2432.

Optionally, in some embodiments, the first processing module further includes a third processor connected to the first memory, and a transmission latency generated when the third processor performs read and write operations on the first memory is less than the transmission latency generated when the first processor communicates with the first processing module.

Optionally, in some embodiments, the first processor is connected to the first processing module through a first bus, the second processor is connected to the first memory through a second bus, the third processor is connected to the first memory through a third bus, and a sum of a bus bit width of the second bus and a bus width of the third bus is greater than a bus bit width of the first bus.

Optionally, in some embodiments, the second processor and the third processor are pipeline pipeline processors.

Optionally, in some embodiments, the circuit further includes a fourth processor and a third memory connected to the fourth processor.

FIG. 1 is still used as an example. The processor 111 may be equivalent to the fourth processor, and the memory 113 may be equivalent to the third memory.

FIG. 2 is still used as an example. The processor 211 may be equivalent to the fourth processor, and the memory 231 may be equivalent to the third memory.

Optionally, in some embodiments, the circuit further includes a fourth processor and a second processing module connected to the fourth processor. The second processing module includes N fifth processors connected to M memories, where both N and M are integers greater than or equal to 1. A transmission latency generated when any fifth processor performs read and write operations on the memory connected to the fifth processor is less than a transmission latency generated when the fourth processor communicates with the second processing module.

FIG. 1 is still used as an example. The processor 114 may be equivalent to the fourth processor, and the processing module 122 may be equivalent to the second processing module.

FIG. 2 is still used as an example. The processor 214 may be equivalent to the fourth processor, and the processing module 222 may be equivalent to the second processing module.

Optionally, in some embodiments, the second processor is connected to the third processor through a fourth bus, the fourth processor is connected to the first processor through a fifth bus, and a bus bit width of the fourth bus is less than a bus bit width of the fifth bus.

FIG. 1 is still used as an example. The bus 21 may be equivalent to the fourth bus, and the bus 41 may be equivalent to the fifth bus.

FIG. 2 is still used as an example. The bus 2421 may be equivalent to the fourth bus, and the bus 2441 may be equivalent to the fifth bus.

Optionally, in some embodiments, a quantity of processor cores included in the fourth processor is greater than or equal to a quantity of processor cores included in the first processor.

Optionally, in some embodiments, the fourth processor and the first processor are pipeline processors.

Optionally, in some embodiments, the first processing module further includes the first memory.

An embodiment of this application further provides an electronic device. The electronic device includes the chip according to embodiments of this application, and the electronic device further includes a receiver and a transmitter. The receiver is configured to receive a packet and send the packet to the chip. The chip is configured to process the packet. The transmitter is configured to: obtain a packet processed by the chip, and send the processed packet to another electronic device. The electronic device may be a switch, a router, or any other electronic device on which the foregoing chip can be disposed.

The chip in embodiments of this application may be a system on chip (system on chip, SoC), a network processor (network processor, NP), or the like.

The memory in embodiments of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example and not limitation, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus dynamic random access memory (direct rambus RAM, DR RAM). It should be noted that the memory of systems and methods described in this specification includes but is not limited to these and any memory of another proper type.

It should be noted that, the processor in embodiments of this application may be an integrated circuit chip, and has a signal processing capability. In an implementation process, steps in the foregoing method embodiments can be implemented by using a hardware integrated logical circuit in the processor, or by using instructions in a form of software. The processor may be a microprocessor, or the processor may be any conventional processor, or the like.

In an implementation process, steps in the foregoing methods can be implemented by using a hardware integrated logical circuit in the processor, or by using instructions in a form of software. The steps of the method disclosed with reference to embodiments of this application may be directly performed by a hardware processor, or may be performed by using a combination of hardware in the processor and a software module. The software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor. To avoid repetition, details are not described herein again.

A person of ordinary skill in the art may be aware that, in combination with the examples described in embodiments disclosed in this specification, units and algorithm steps may be implemented by using electronic hardware or a combination of computer software and electronic hardware. Whether the functions are performed by using hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In several embodiments according to this application, it should be understood that the disclosed system, apparatus, and method may be implemented in other manners. For example, the described apparatus embodiments are merely examples. For example, division into the units is merely logical function division and there may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit, wherein the circuit comprises a first processor and a first processing module connected to the first processor, the first processing module comprises a second processor connected to a first memory, and a transmission latency generated when the second processor performs read and write operations on the first memory is less than a transmission latency generated when the first processor communicates with the first processing module.

2. The circuit according to claim 1, wherein the second processor is a multi-core processor, and the transmission latency generated when the second processor performs the read and write operations on the first memory is a transmission latency generated when any core processor of the multi-core processor comprised in the second processor performs read and write operations on the first memory.

3. The circuit according to claim 1 or 2, wherein the first processor is connected to the first processing module through a first bus, and the second processor is connected to the first memory through a second bus, wherein a bus bit width of the second bus is greater than a bus bit width of the first bus, and/or a length of the second bus is less than a length of the first bus.

4. The circuit according to claim 1 or 2, wherein the first processing module further comprises a third processor connected to a second memory, and a transmission latency generated when the third processor performs read and write operations on the second memory is less than the transmission latency generated when the first processor communicates with the first processing module.

5. The circuit according to claim 4, wherein the first processor is connected to the first processing module through a first bus, the second processor is connected to the first memory through a second bus, the third processor is connected to the second memory through a third bus, and a sum of a bus bit width of the second bus and a bus width of the third bus is greater than a bus bit width of the first bus.

6. The circuit according to claim 1 or 2, wherein the first processing module further comprises a third processor connected to the first memory, and a transmission latency generated when the third processor performs read and write operations on the first memory is less than the transmission latency generated when the first processor communicates with the first processing module.

7. The circuit according to claim 6, wherein the first processor is connected to the first processing module through a first bus, the second processor is connected to the first memory through a second bus, the third processor is connected to the first memory through a third bus, and a sum of a bus bit width of the second bus and a bus width of the third bus is greater than a bus bit width of the first bus.

**8.** The circuit according to any one of claims 4 to 7, wherein the second processor and the third processor are pipeline pipeline processors.

**9.** The circuit according to any one of claims 1 to 3, wherein the circuit further comprises a fourth processor and a third memory connected to the fourth processor; or
the circuit further comprises a fourth processor and a second processing module connected to the fourth processor; the second processing module comprises N fifth processors connected to M memories, wherein both N and M are integers greater than or equal to 1; and a transmission latency generated when any fifth processor performs read and write operations on the memory connected to the fifth processor is less than a transmission latency generated when the fourth processor communicates with the second processing module.

**10.** The circuit according to any one of claims 4 to 8, wherein the circuit further comprises a fourth processor and a third memory connected to the fourth processor; or
the circuit further comprises a fourth processor and a second processing module connected to the fourth processor; the second processing module comprises N fifth processors connected to M memories, wherein both N and M are integers greater than or equal to 1; and a transmission latency generated when any fifth processor performs read and write operations on the memory connected to the fifth processor is less than a transmission latency generated when the fourth processor communicates with the second processing module.

**11.** The circuit according to claim 10, wherein the second processor is connected to the third processor through a fourth bus, the fourth processor is connected to the first processor through a fifth bus, and a bus bit width of the fourth bus is less than a bus bit width of the fifth bus.

**12.** The circuit according to any one of claims 9 to 11, wherein a quantity of processor cores comprised in the fourth processor is greater than or equal to a quantity of processor cores comprised in the first processor.

**13.** The circuit according to any one of claims 9 to 12, wherein the fourth processor and the first processor are pipeline processors.

**14.** The circuit according to any one of claims 1 to 13, wherein the first processing module further comprises the first memory.

**15.** A chip, wherein the chip comprises the circuit according to any one of claims 1 to 14.

**16.** An electronic device, wherein the electronic device comprises the chip according to claim 15, and the electronic device further comprises a receiver and a transmitter, wherein the receiver is configured to receive a packet and send the packet to the chip;

the chip is configured to process the packet; and
the transmitter is configured to: obtain a packet processed by the chip, and send the processed packet to another electronic device.

Input/Output interface
101
Chip
100
61
51
Processor
111
Memory
131
41
11
Processor
112
Processing module
121
42
52
Processor
113
Memory
132
43
62
Processor
114
12
Processing module
122
Processing module
121
Processor
1211
Memory
1221
21
31
Processor
1212
Memory
1222
32
Processing module
122
Processor
1213
Memory
1223
22
33
Processor
1214
Memory
1224
23
34
Processor
1215
Memory
1225
35

FIG. 1

Chip
200
Memory
231
Memory
232
Memory
233
Memory
234
Memory
235
Memory
236
Memory
237
2471
2472
2473
2474
2475
2476
2477
Input/Output interface 201
2461
2462
2431
2432
2433
2434
2435
Processor
2211
Processor
2212
2421
Processing
module 221
Processor
2213
Processor
2214
Processor
2215
2422
2423
Processing
module 222
2411
2412
Processor
211
Processor
212
Processor
213
Processor
214
2441
2442
2443

FIG. 2

Memory
321
Memory
322
Memory
323
333
334
335
Processing
module
310
Processor
311
332
Processor
312
332
Processor
313
331
Processor
301

FIG. 3

Memory
411
Memory
412
Memory
413
421
422
423
424
424
Processor
401
Processor
402
Processor
403

FIG. 4

Processor 401
Memory 411
Processor 402
Memory 412
Processor 403
Memory 413
501: Obtain a routing table index 1
502: Routing table index 1
503: Routing entry table 1
504: Determine an entry corresponding to flow identifier information
505: PS
506: Obtain a routing table index 2, a base address, and a hash value
507: Routing table index 2
508: Routing entry table 2
509: Query an entry corresponding to the base address and the hash value
510: PS
511: Obtain a routing table index 3 and a port index
512: Routing table index 3
513: Routing entry table 3
514: Query an entry corresponding to the port index
515: Write a next-hop port into the PS, and send the PS to a next node

FIG. 5

Processor 301
Processor 311
Memory 321
Processor 312
Memory 322
Processor 313
Memory 323
601: Obtain a routing table index 1, flow identifier information, and a hash value
602: Routing table index 1, flow identifier information, and hash value
603: Routing table index 1
604: Routing entry table 1
605: Determine an entry corresponding to the flow identifier information
606: PS
607: Obtain a routing table index 2, a base address, and the hash value
TO FIG. 6B
TO FIG. 6B
TO FIG. 6B
TO FIG. 6B
TO FIG. 6B
TO FIG. 6B
TO FIG. 6B

FIG. 6A

CONT. FROM FIG. 6A
CONT. FROM FIG. 6A
CONT. FROM FIG. 6A
CONT. FROM FIG. 6A
CONT. FROM FIG. 6A
CONT. FROM FIG. 6A
CONT. FROM FIG. 6A
608: Routing table index 2
609: Routing entry table 2
610: Query an entry corresponding to the base address and the hash value
611: PS
612: Obtain a routing table index 3 and a port index
613: Routing table index 3
614: Routing entry table 3
615: Query an entry corresponding to the port index
616: Next-hop port
617: Write the next-hop port into the PS, and send the PS to a next node

FIG. 6B

## INTERNATIONAL SEARCH REPORT

International application No.
**PCT/CN2021/115618**

**A. CLASSIFICATION OF SUBJECT MATTER**

G06F 3/06(2006.01)i

According to International Patent Classification (IPC) or to both national classification and IPC

**B. FIELDS SEARCHED**

Minimum documentation searched (classification system followed by classification symbols)

G06F

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT: 处理器, 存储器, 时延, 通信, processor, memory, latency, communication

**C. DOCUMENTS CONSIDERED TO BE RELEVANT**

| Category* | Citation of document, with indication, where appropriate, of the relevant passages | Relevant to claim No. |
|---|---|---|
| X | WO 2018188084 A1 (HUAWEI TECHNOLOGIES CO., LTD.) 18 October 2018 (2018-10-18)<br>description page 8 line 39 to page 17 line 9, figure 3 | 1-16 |
| X | CN 107291392 A (ZHENGZHOU YUNHAI INFORMATION TECHNOLOGY CO., LTD.) 24 October 2017 (2017-10-24)<br>description paragraphs 27-51 | 1-16 |
| A | CN 106462498 A (LIQID INC.) 22 February 2017 (2017-02-22)<br>entire document | 1-16 |
| A | CN 108139971 A (HUAWEI TECHNOLOGIES CO., LTD.) 08 June 2018 (2018-06-08)<br>entire document | 1-16 |
| A | CN 108920111 A (CHINA UNITED NETWORK COMMUNICATIONS GROUP CO., LTD.) 30 November 2018 (2018-11-30)<br>entire document | 1-16 |
| A | CN 109582215 A (HUAWEI TECHNOLOGIES CO., LTD.) 05 April 2019 (2019-04-05)<br>entire document | 1-16 |

☑ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **02 November 2021** | **02 December 2021** |

Name and mailing address of the ISA/CN

**China National Intellectual Property Administration (ISA/CN)**
**No. 6, Xitucheng Road, Jimenqiao, Haidian District, Beijing 100088, China**

Facsimile No. **(86-10)62019451**

Authorized officer

Telephone No.

Form PCT/ISA/210 (second sheet) (January 2015)

INTERNATIONAL SEARCH REPORT

International application No.
PCT/CN2021/115618

C. DOCUMENTS CONSIDERED TO BE RELEVANT

| Category* | Citation of document, with indication, where appropriate, of the relevant passages | Relevant to claim No. |
|---|---|---|
| A | US 9588898 B1 (WESTERN DIGITAL TECHNOLOGIES, INC.) 07 March 2017 (2017-03-07) entire document | 1-16 |
| A | US 2004215926 A1 (IBM) 28 October 2004 (2004-10-28) entire document | 1-16 |

Form PCT/ISA/210 (second sheet) (January 2015)

**INTERNATIONAL SEARCH REPORT**
**Information on patent family members**

International application No.
**PCT/CN2021/115618**

| Patent document cited in search report | Publication date (day/month/year) | Patent family member(s) | Publication date (day/month/year) |
|---|---|---|---|
| WO 2018188084 A1 | 18 October 2018 | EP 3598313 A1 | 22 January 2020 |
| | | EP 3598313 B1 | 30 June 2021 |
| | | CN 110419034 A | 05 November 2019 |
| | | US 2020050551 A1 | 13 February 2020 |
| | | CN 110419034 B | 08 January 2021 |
| CN 107291392 A | 24 October 2017 | None | |
| CN 106462498 A | 22 February 2017 | WO 2015200313 A1 | 30 December 2015 |
| | | EP 3158455 A1 | 26 April 2017 |
| | | EP 3158455 B1 | 18 March 2020 |
| | | US 2015370665 A1 | 24 December 2015 |
| | | US 10180889 B2 | 15 January 2019 |
| | | CN 106462498 B | 02 August 2019 |
| CN 108139971 A | 08 June 2018 | EP 3511837 A1 | 17 July 2019 |
| | | US 2019220434 A1 | 18 July 2019 |
| | | US 10678738 B2 | 09 June 2020 |
| | | WO 2018058430 A1 | 05 April 2018 |
| | | CN 108139971 B | 16 October 2020 |
| CN 108920111 A | 30 November 2018 | CN 108920111 B | 28 May 2021 |
| CN 109582215 A | 05 April 2019 | WO 2019062202 A1 | 04 April 2019 |
| | | US 2020150903 A1 | 14 May 2020 |
| | | CN 109582215 B | 09 October 2020 |
| US 9588898 B1 | 07 March 2017 | None | |
| US 2004215926 A1 | 28 October 2004 | US 7526631 B2 | 28 April 2009 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202011060780
- CN 202011176149